# FASCICULE DE BREVET EUROPEEN

(11) **EP 2 585 796 B1**
(45) Date de publication et mention de la délivrance du brevet: **08.03.2017**
(21) Numéro de dépôt: 11736425.7
(22) Date de dépôt: 22.06.2011
(51) Int. Cl.: G01D 3/08, B64D 15/20, G01K 15/00, G01R 31/28, F01D 17/08

(54) **PROCÉDÉ DE DÉTECTION D'UNE PANNE DES MOYENS DE DÉGIVRAGE D'UNE SONDE DE MESURE D'UN PARAMÈTRE PHYSIQUE**
VERFAHREN ZUR ERKENNUNG EINES DEFEKTS BEI EINER VORRICHTUNG ZUR ENTEISUNG EINER SONDE ZUR MESSUNG EINES PHYSIKALISCHEN PARAMETERS
METHOD OF DETECTING A FAULT WITH THE MEANS FOR DE-ICING A PROBE FOR MEASURING A PHYSICAL PARAMETER

(30) Priorité: 25.06.2010 FR 1055121
(43) Date de publication de la demande: 01.05.2013
(73) Titulaire: Snecma, 75015 Paris (FR)
(72) Inventeur: BIRAUD, Benoît, F-77550 Moissy Cramayel Cedex (FR); GODEL, Franck, F-77550 Moissy Cramayel Cedex (FR)
(74) Mandataire: Robert, Mathias
(86) Numéro de dépôt international: PCT/FR2011/051433
(87) Numéro de publication internationale: WO 2011/161377

(56) Documents cités:
- FR-A1- 2 785 389
- GB-A- 756 529
- GB-A- 840 509
- US-A- 5 523 959

## Description

La présente invention concerne un procédé de détection d'une panne des moyens de dégivrage d'une sonde de mesure d'un paramètre physique, telle qu'une sonde de mesure de la température d'un moteur d'avion.

Un moteur d'avion est équipé de sondes qui, en fonction de leurs emplacements, peuvent être soumises à une formation de givre. La glace formée sur la sonde fausse sa mesure. Une mesure de température par exemple est notamment utilisée afin d'ajuster les positions d'aubes de stator à calage variable dans le compresseur du moteur. Une erreur de mesure peut entraîner un risque de pompage du moteur et, par conséquent, une perte importante de poussée ou l'arrêt du moteur.

Afin d'éviter cela, des moyens de dégivrage sont prévus pour faire fondre la glace formée sur la sonde, ces moyens comportant une résistance chauffante disposée à l'intérieur du corps de la sonde.

L'utilisation de moyens de dégivrage est notamment connue des documents GB 756 529, US 5,523,959 et GB 840 509.

Bien que l'élément sensible de la sonde, permettant de mesurer la température, ne soit pas directement chauffé par la résistance, il enregistre une augmentation de la température par chauffage par convection. L'erreur de mesure engendrée par le chauffage de la sonde lors du fonctionnement du moteur est compensée par un logiciel modifiant la valeur de la température mesurée de plusieurs degrés.

Toutefois, l'efficacité et le fonctionnement réels des moyens de dégivrage ne sont pas garantis par la technique connue, celle-ci ne permettant pas de détecter une panne des moyens de dégivrage de la sonde.

L'invention a notamment pour but d'apporter une solution simple, efficace et économique à ce problème.

A cet effet, elle propose un procédé de détection d'une panne des moyens de dégivrage d'une sonde de mesure d'un paramètre physique sur un moteur d'avion, caractérisé en ce qu'il comporte les étapes successives consistant à :
- mesurer une première valeur du paramètre physique à l'aide de la sonde, au sol et avant démarrage du moteur ;
- activer les moyens de dégivrage de la sonde ;
- à l'issue d'une durée déterminée à compter du début du dégivrage, mesurer une seconde valeur du paramètre à l'aide de la sonde ;
- comparer les deux valeurs et générer un signal de panne si la différence entre les deux valeurs est inférieure à un seuil déterminé.

Si la différence entre les deux valeurs est supérieure au seuil, il est possible de garantir le bon fonctionnement des moyens de dégivrage. A l'inverse, si cette différence est inférieure au seuil, il est nécessaire d'avertir un opérateur de la panne des moyens de dégivrage.

Selon une caractéristique de l'invention, le paramètre mesuré à l'aide de la sonde est la température.

Dans ce cas, la valeur seuil est par exemple comprise entre 4 et 8° Kelvins, préférentiellement de l'ordre de 5° Kelvins.

En variante, le paramètre mesuré à l'aide de la sonde est la pression.

Les étapes précitées sont exécutées avant le démarrage du moteur, afin d'éviter que la mesure du paramètre par la sonde soit modifiée par le flux d'air traversant le moteur.

Selon une autre caractéristique de l'invention, la seconde valeur du paramètre est mesurée à l'aide de la sonde après une durée comprise entre 10 secondes et 1 minute, par exemple de l'ordre de 20 secondes, à compter du début du dégivrage.

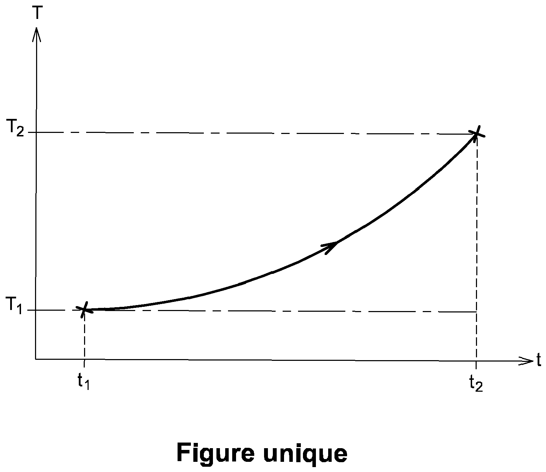

L'invention sera mieux comprise et d'autres détails, caractéristiques et avantages de l'invention apparaîtront à la lecture de la description suivante faite à titre d'exemple non limitatif en référence au dessin annexé dans lequel la figure unique est un diagramme illustrant l'évolution de la température mesurée par la sonde en fonction du temps, lors du dégivrage.

La figure unique illustre le fonctionnement normal d'une sonde de température d'un moteur d'avion, en particulier d'une sonde placée au niveau d'un compresseur basse pression du moteur. Comme cela est connu en soi, le corps de la sonde est équipée de moyens de dégivrage comprenant une résistance chauffante permettant de faire fondre la glace accumulée sur le corps de la sonde, le moteur étant en outre équipé d'un calculateur dont l'une des fonctions est détaillée ci-après en référence à la figure unique.

L'invention propose un test permettant de vérifier l'efficacité et le fonctionnement des moyens de dégivrage précités avant démarrage du moteur, et lors duquel une première valeur de température T₁ est mesurée à un instant t₁, puis les moyens de dégivrage sont activés, afin de chauffer le corps de la sonde par convection. Lors de cette étape, en fonctionnement normal, la température T mesurée par la sonde augmente, comme cela est visible sur la courbe de la figure unique.

A l'issue d'une durée (t₂-t₁) comprise entre 10 secondes et 1 minute, préférentiellement de l'ordre de 20 secondes à compter du début du dégivrage, une seconde valeur de la température T₂ est mesurée à l'aide de la sonde.

Si la différence entre les deux valeurs de température T₁ et T₂ est supérieure à une valeur seuil comprise entre 4 et 8° Kelvins, préférentiellement de l'ordre de 5° Kelvins, le calculateur en déduit que les moyens de dégivrage fonctionnent correctement. A l'inverse, si la différence de température est inférieure à cette valeur seuil, le calculateur en déduit que les moyens de dégivrage sont en panne et délivre alors un signal de panne correspondant, destiné à avertir un opérateur.

L'invention s'applique également à une sonde de pression, en particulier montée sur un moteur d'avion.

## Revendications

1. Procédé de détection d'une panne des moyens de dégivrage d'une sonde de mesure de température ou de pression sur un moteur d'avion, **caractérisé en ce qu'**il comporte les étapes successives consistant à :
- mesurer une première valeur (T₁) de température ou de pression à l'aide de la sonde, avant démarrage du moteur ;
- activer les moyens de dégivrage de la sonde ;
- à l'issue d'une durée déterminée (t₂ - t₁) à compter du début du dégivrage, mesurer une seconde valeur (T₂) de température ou de pression à l'aide de la sonde ;
- comparer les deux valeurs et générer un signal de panne si la différence entre les deux valeurs est inférieure à un seuil déterminé.

2. Procédé selon la revendication 1, **caractérisé en ce que** la seconde valeur du paramètre est mesurée à l'aide de la sonde après une durée (t₂ - t₁) comprise entre 10 secondes et 1 minute, par exemple de l'ordre de 20 secondes, à compter du début du dégivrage.

## Patentansprüche

1. Verfahren zur Erkennung einer Störung der Enteisungsmittel eines Temperatur- oder Druckmessfühlers an einem Flugzeugmotor, **dadurch gekennzeichnet, dass** es eine Folge von Schritten umfasst, die bestehen aus:
- der Messung eines ersten Temperatur- oder Druckwerts (T₁) mithilfe des Fühlers, bevor der Motor angelassen wird;
- der Aktivierung der Enteisungsmittel des Fühlers;
- nach einer bestimmten Dauer (t₂-t₁) ab dem Zeitpunkt des Enteisungsbeginns die Messung eines zweiten Temperatur- oder Druckwerts (T₂) mithilfe des Fühlers;
- das Vergleichen der beiden Werte miteinander und das Generieren eines Störsignals, wenn die Differenz zwischen den beiden Werten einen bestimmten Grenzwert unterschreitet.

2. Verfahren nach Anspruch 1, **dadurch gekennzeichnet, dass** der zweite Wert des Parameters mithilfe des Fühlers nach einer Dauer (t₂-t₁) gemessen wird, die zwischen 10 Sekunden und 1 Minute liegt, beispielsweise 20 Sekunden ab Beginn der Enteisung.

## Claims

1. A method of detecting a fault in de-icer means of a probe for measuring temperature or pressure on an airplane engine, the method being **characterized in that** it comprises the successive steps consisting in:
prior to starting the engine, measuring a first value (T₁) of the temperature or pressure with the help of the probe;
• activating the probe de-icer means;
• at the end of a determined duration (t₂-t₁) from the start of de-icing, measuring a second value (T₂) of the temperature or pressure with the help of the probe; and
• comparing these two values and generating a fault signal if the difference between the two values is less than a determined threshold.

2. A method according to claim 1, **characterized in that** the second value of the parameter is measured with the help of the probe after a duration (t₂-t₁) lying in the range 10 seconds to 1 minute from the start of de-icing, e.g. equal to about 20 seconds.
